(19) Europäisches Patentamt
European Patent Office
Office européen des brevets

(11) **EP 2 648 044 A2**

(12) **EUROPEAN PATENT APPLICATION**

(43) Date of publication:
**09.10.2013  Bulletin 2013/41**

(51) Int Cl.:
***G03F 9/00*** (2006.01)

(21) Application number: **13158297.5**

(22) Date of filing: **08.03.2013**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **04.04.2012  JP 2012085895**

(71) Applicant: **Canon Kabushiki Kaisha
Tokyo 146-8501 (JP)**

(72) Inventor: **Okuda, Hiroshi
Tokyo 146-8501 (JP)**

(74) Representative: **TBK
Bavariaring 4-6
80336 München (DE)**

(54) **Measurement apparatus and measurement method**

(57)    A measurement apparatus, which measures a surface position of an object (111) by detecting interfering light between measurement light reflected by the object and reference light reflected by a reference surface, includes: a detector (114) configured to detect the interfering light to output an interference signal; and a processor (115) configured to obtain the surface position based on a sine signal and a cosine signal which are obtained from the interference signal output from the detector and have a phase corresponding to an optical path length difference between the measurement light and the reference light. The processor includes a correction processing unit (211, 212, 213, 214) configured to correct the sine signal and the cosine signal to reduce frequency noise components contained in the sine signal and the cosine signal.

## FIG. 6

EP 2 648 044 A2

**Description**

BACKGROUND OF THE INVENTION

Field of the Invention

The present invention relates to a measurement apparatus and measurement method for a surface position.

Description of the Related Art

As measurement apparatuses for measuring the surface position of an object to be measured at high accuracy, measurement apparatuses using a laser interferometer are widely used. These measurement apparatuses calculate the optical path difference between reference light and measurement light at high accuracy from the phase difference of an interference signal generated by the interference between the reference light and the measurement light. To calculate the phase difference of the interference signal at high accuracy, a measurement apparatus disclosed in Japanese Patent Laid-Open No. 2008-510170 uses a heterodyne calculation method, and a measurement apparatus in Japanese Patent Laid-Open No. 2006-170796 uses a homodyne calculation method. These measurement apparatuses calculate the phase difference at high accuracy by calculating the sine and cosine components of the phase difference of an interference signal, and performing arctangent calculation for them. The calculated phase difference has a value within a range of $-\pi$ to $+\pi$. Thus, by connecting the order of the calculated phase difference, these measurement apparatuses calculate the optical path difference between reference light and measurement light, that is, the surface position of an object to be measured.

When the surface of an object to be measured is rough and its surface position is to be calculated by interference measurement, the reflectance on the surface of the object may greatly change and decrease, compared to an object to be measured having a mirror surface. In this case, the S/N ratio of the interference signal decreases, and the sine and cosine components of the phase difference contain high-frequency noise. If arctangent calculation is executed for the sine and cosine components containing the high-frequency noise, calculated values greatly vary. In order connection, an order may be wrong, greatly decreasing the measurement accuracy.

SUMMARY OF THE INVENTION

The present invention provides a measurement apparatus and measurement method for measuring the surface position of an object to be measured at high accuracy.

The present invention in its first aspect provides a measurement apparatus as specified in claims 1 to 7, 11 and 12.

The present invention in the second aspect provides a measurement method as specified in claims 8 to 10.

Further features of the present invention will become apparent from the following description of exemplary embodiments with reference to the attached drawings.

BRIEF DESCRIPTION OF THE DRAWINGS

Fig. 1 is a view showing a measurement apparatus according to the first embodiment;
Fig. 2 is a diagram showing a phase calculating circuit according to the first embodiment;
Fig. 3 is a graph showing the frequency characteristic of a cascaded integrator comb filter;
Fig. 4 is a graph for explaining order connection when the S/N ratio of a measurement signal is high;
Fig. 5 is a graph for explaining order connection when the S/N ratio of a measurement signal is low;
Fig. 6 is a diagram showing another example of the phase calculating circuit according to the first embodiment;
Fig. 7 is a graph showing the frequency characteristic of a low-pass filter;
Fig. 8 is a view for explaining the states of incident light and reflected light on the surface of an object to be measured;
Fig. 9 is a view showing a measurement apparatus according to the second embodiment;
Fig. 10 is a diagram showing a phase calculating circuit according to the second embodiment; and
Fig. 11 is a diagram showing a phase calculating circuit according to the third embodiment.

DESCRIPTION OF THE EMBODIMENTS

[First Embodiment]

[Arrangement of Measurement Apparatus]

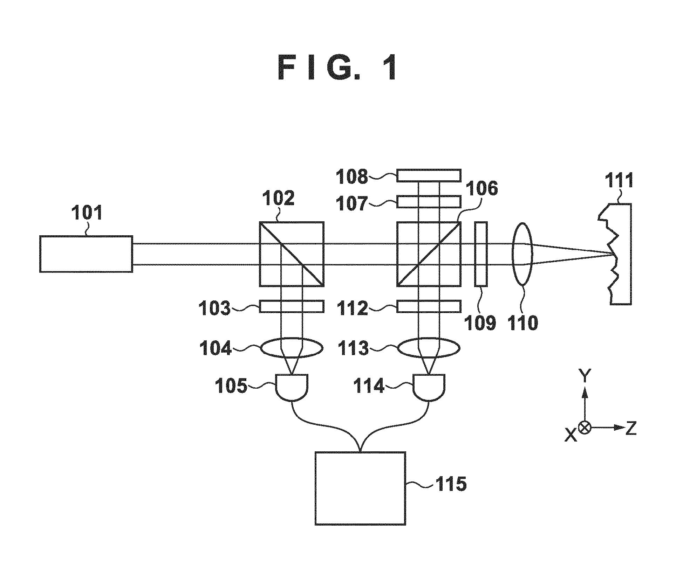

The arrangement of a measurement apparatus according to the first embodiment will be described. Fig. 1 is a view showing the overall measurement apparatus according to the first embodiment. The measurement apparatus measures the surface position of an object 111 to be measured. The surface shape of the object 111 to be measured can be obtained by measuring respective positions on the entire surface. The surface of the object 111 to be measured is assumed to be rough. The measurement apparatus according to the first embodiment calculates the phase of an interference signal according to the heterodyne method. A light source 101 is a heterodyne light source, and  emits S-polarized light having a frequency $f_S$ and P-polarized light having a frequency $f_P$. These beams reach a non-polarization beam splitter 102, part of the incident light is reflected by the non-polarization beam splitter 102, and the remaining part passes through the non-polarization beam splitter 102.

The light reflected by the non-polarization beam splitter 102 passes through an analyzer 103 having a polarization axis inclined at 45°. The light having passed through the analyzer 103 enters a condenser lens 104 and is received by a detector 105. An interference signal received by the detector 105 will be called a reference signal. In contrast, the light having passed through the non-polarization beam splitter 102 reaches a polarization beam splitter 106, S-polarized light is reflected by the polarization beam splitter 106, and P-polarized light passes through the polarization beam splitter 106. The S-polarized light reflected by the polarization beam splitter 106 passes through a λ/4 plate 107 to change into circularly polarized light, is reflected by the reference surface of a reference mirror 108, passes again through the λ/4 plate 107 to change into P-polarized light, and enters again the polarization beam splitter 106. The light which reaches again the polarization beam splitter 106 passes through the polarization beam splitter 106 because it is P-polarized light. The light reflected by the  reference surface will be called reference light.

To the contrary, the P-polarized light having passed first through the polarization beam splitter 106 passes through a λ/4 plate 109 to change into circularly polarized light, has its beam diameter narrowed down through a condenser lens 110, and is reflected by the surface of the object 111 to be measured which is arranged near the beam spot position. The light reflected to have a large beam diameter changes into parallel light through the condenser lens 110, passes again through the λ/4 plate 109 to change into S-polarized light, and reaches again the polarization beam splitter 106. The light which reaches again the polarization beam splitter 106 is reflected by the polarization beam splitter 106 because it is S-polarized light. The light reflected by the surface of the object 111 to be measured will be called measurement light. The polarization beam splitter 106 multiplexes the reference light and measurement light, generating interfering light. The interfering light passes through an analyzer 112 having a polarization axis inclined at 45°. The interfering light having passed through the analyzer 112 enters a condenser lens 113 and is received by a detector 114. The interference signal of the interfering light received by the detector 114 will be called a measurement signal.

The signals received by the detectors 105  and 114 are sent to a processor 115. The processor 115 processes the received signals to calculate a phase corresponding to the surface position of a point irradiated with measurement light on the surface of the object 111 to be measured. The processor 115 obtains the surface shape of the object 111 to be measured by calculating the phase of each point while moving the object 111 in the X and Y directions. The surface of the object 111 to be measured is rough and corrugated. When the object 111 to be measured is moved in the X and Y directions, the surface position (position in the Z direction) changes depending on the corrugations, generating a Doppler shift.

[Relationship between Interference Signal and Surface Position (Position in Z Direction)]

The phase of a point (x, y) irradiated with a beam on the object 111 to be measured is represented by φ(x, y, t) containing the Doppler shift. That is, the phase φ(x, y, t) corresponds to the optical path length difference between measurement light and reference light. A reference signal $I_{ref}(t)$ and a measurement signal $I_{sig}(t, φ(x, y, t))$ at given time t are represented by equations (1) and (2), respectively:

$$I_{ref}(t) = C_0{}^{ref} + C_1{}^{ref}\cos(2\pi\Delta ft) \qquad \qquad ...(1)$$

$$I_{sig}(t, \varphi(x, y, t)) = C_0{}^{sig}(x, y, t) + C_1{}^{sig}(x, y, t)\cos(2\pi\Delta ft - \varphi(x, y, t)) \qquad ...(2)$$

$\Delta f$, which is generally called a beat frequency, is given by equation (3) :

$$\Delta f = f_s - f_p \qquad ...(3)$$

The beat frequency $\Delta f$ is generated using, for example, an acousto-optic modulator (AOM) or a Zeeman effect. The AOM is an optical element in which an ultrasonic wave propagating through the crystal functions as a pseudo-diffraction grating to generate diffracted light having a frequency obtained by modulating the frequency of incident light by that of the ultrasonic wave. The Zeeman effect is an effect of slightly separating the emission spectrum of an atom by applying a magnetic field into a laser. In equations (1) and (2), $C_0{}^{ref}$, $C_1{}^{ref}$, $C_0{}^{sig}(x, y, t)$, and $C_1{}^{sig}(x, y, t)$ are proportionality coefficients. The proportionality coefficients $C_0{}^{sig}(x, y, t)$ and $C_1{}^{sig}(x, y, t)$ of the measurement signal $I_{sig}$ are functions of (x, y, t). This is because the position of the point (x, y) irradiated with measurement light on the object 111 to be measured changes with time t, and thus the reflectance on the surface of the object 111 to be measured changes.

A Doppler shift $f_{Dop}$ is given by equation (4) :

$$f_{Dop} = d\varphi(x, y, t)/dt = 2v(x, y, t)/\lambda_{sig} \qquad ...(4)$$

where v(x, y, t) is the rate of change of the surface position z, and $\lambda_{sig}$ is the light source wavelength on the measurement optical path side.

Hence, the surface position z (x, y, t) to be obtained is given by equation (5) :

$$z(x, y, t) = \int v(x, y, t)dt \qquad ...(5)$$

The processor 115 calculates the phase $\varphi(x, y, t)$ containing the Doppler shift $f_{Dop}$ from the reference signal $I_{ref}$ in equation (1) and the measurement signal $I_{sig}$ in equation (2), calculates the rate v(x, y, t) of change of the surface position z from it, and finally integrates the rate, obtaining the surface position z.

[Calculation of Surface Position z]

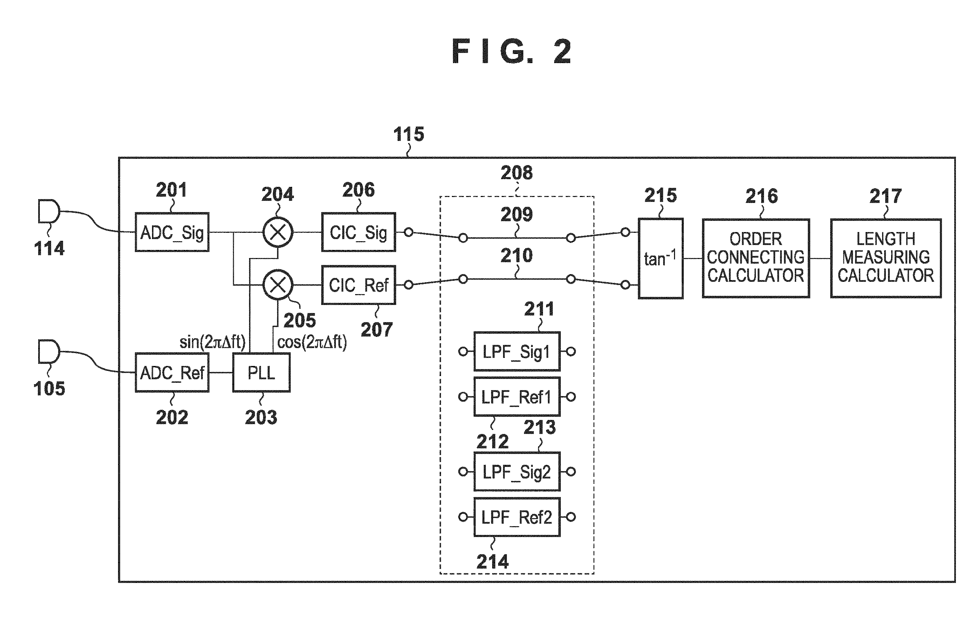

A phase calculating circuit according to the first embodiment will be described with reference to Fig. 2. A low-pass filter switching circuit, which is a feature of the first embodiment, will be explained particularly in detail in addition to a description of order connection and an order connection error. Fig. 2 shows in detail the detectors 105 and 114 and the processor 115.

The reference signal $I_{ref}$ represented by equation (1) and the measurement signal $I_{sig}$ represented by equation (2) are received by the detector 105 and the detector 114, respectively, and sent to the processor 115. The reference signal $I_{ref}$ and measurement signal $I_{sig}$ are converted into digital signals by analog-to-digital converters (ADCs) 201 and 202. For example, when the beat frequency $\Delta f$ is 20 MHz, the sampling frequency of the ADC needs to be about 100 MHz.

Then, a phase locked loop (PLL) 203 generates two signals sin $(2\pi\Delta ft)$ and cos $(2\pi\Delta ft)$ based on the digital reference signal $I_{ref}$. A mixer 204 generates an integrated signal of the digital measurement signal $I_{sig}$ and sin $(2\pi\Delta ft)$ generated by the PLL 203. A mixer 205 generates an integrated signal of the digital measurement signal $I_{sig}$ and cos $(2\pi\Delta ft)$ generated by the PLL 203. The digital signal generated by the mixer 204 is given by expression (6) :

$$(1/2)\text{C}_1{}^{\text{sig}}(\text{x, y, t})\sin(\varphi(\text{x, y, t})) + \text{C}_0{}^{\text{sig}}(\text{x, y,}$$

$$\text{t})\sin(2\pi\Delta\text{ft}) + (1/2)\text{C}_1{}^{\text{sig}}(\text{x, y, t})\sin(4\pi\Delta\text{ft} - \varphi(\text{x, y,}$$

$$\text{t})) \qquad\qquad\qquad\qquad ...(6)$$

The digital signal generated by the mixer 205 is given by expression (7) :

$$(1/2)\text{C}_1{}^{\text{sig}}(\text{x, y, t})\cos(\varphi(\text{x, y, t})) + \text{C}_0{}^{\text{sig}}(\text{x, y,}$$

$$\text{t})\cos(2\pi\Delta\text{ft}) + (1/2)\text{C}_1{}^{\text{sig}}(\text{x, y, t})\cos(4\pi\Delta\text{ft} - \varphi(\text{x, y,}$$

$$\text{t})) \qquad\qquad\qquad\qquad ...(7)$$

In each of the digital signals generated by the mixers 204 and 205, the first term is the frequency $\varphi(x, y, t)$ component, the second term is the frequency $\Delta f$ component, and the third term is the frequency $(2\Delta f - \varphi(x, y, t))$ component. Therefore, to calculate the phase $\varphi(x, y, t)$, the second and third term components need to be eliminated first. Cascaded integrator comb (CIC) filters 206 and 207 eliminate the second and third term components from the digital signals generated by the mixers 204 and 205, respectively. A frequency characteristic H(f) of the CIC filter with respect to the frequency f is given by equation (8) :

$$\left| H(f) \right| = \left| \frac{\sin\left( \dfrac{2\pi R}{f_{sampling}} f \right)}{\sin\left( \dfrac{2\pi}{M f_{sampling}} f \right)} \right|^{N} \qquad\qquad ...(8)$$

where $f_{sampling}$ is the sampling frequency of the ADC, and R, M, and N are parameters unique to the CIC filters 206 and 207 that determine a filter shape.

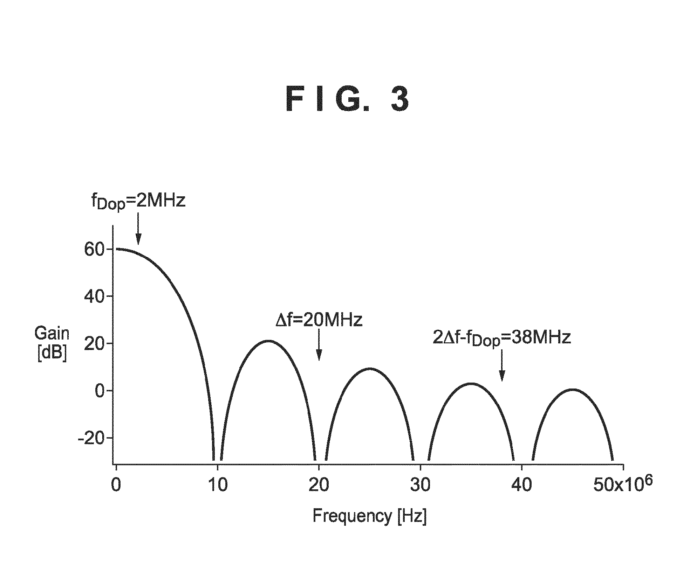

Fig. 3 shows the frequency characteristic H(f) of the CIC filters 206 and 207 for $f_{sampling}$ = 100 MHz, R = 5, M = 2, and N = 3. In Fig. 3, the ordinate represents the gain [dB], and the abscissa represents the frequency [Hz]. In Fig. 3, arrows indicate the frequency components of the first to third terms in expressions (6) and (7) for the beat frequency $\Delta f$ = 20 MHz and the Doppler shift $f_{Dop}$ = 2 MHz. The CIC filters 206 and 207 sufficiently reduce the second and third term components with respect to the first term components in expressions (6) and (7). Thus, the digital signals having passed through the CIC filters 206 and 207 are given by expressions (9) and (10) :

$$(\text{G}_{\text{CIC}}/2)\text{C}_1{}^{\text{sig}}(\text{x, y, t})\sin(\varphi(\text{x, y, t})) \qquad ...(9)$$

$$(\text{G}_{\text{CIC}}/2)\text{C}_1{}^{\text{sig}}(\text{x, y, t})\cos(\varphi(\text{x, y, t})) \qquad ...(10)$$

where $G_{CIC}$ is the gain of the CIC filters 206 and 207. The signal represented by expression (9) is a sine signal having the phase $\varphi$ corresponding to the optical path length difference between measurement light and reference light. The signal given by expression (10) is a cosine signal having the phase $\varphi$ corresponding to the optical path length difference between measurement light and reference light.
Next, a low- pass filter (LPF) switching circuit 208 surrounded by a dotted line in Fig. 2 will be explained in detail. The LPF switching circuit 208 is a feature in the first embodiment. When a measurement signal detected by the detector 114 has a high S/N ratio, digital signals having passed through the CIC filters 206 and 207 are represented by expressions (9) and (10) . In this case, the LPF switching circuit 208 uses straight circuits 209 and 210 so that the digital signals are directly supplied to an arctangent calculator 215, as shown in Fig. 2.

The arctangent calculator 215 calculates an arctangent represented by equation (11) using the two digital signals represented by expressions (9) and (10) :

$$\tan^{-1}[\{(G_{CIC}/2)C_1^{sig}(x, y, t))\sin(\varphi(x, y, t))\}/\{(G_{CIC}/2)C_1^{sig}(x, y, t)\cos(\varphi(x, y, t))\}] = \varphi(x, y, t) \qquad ...(11)$$

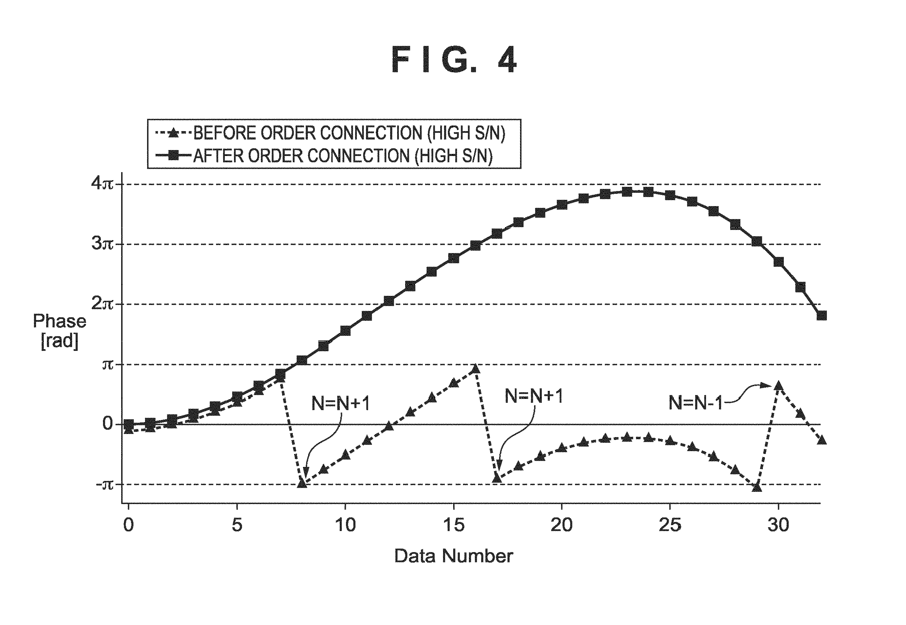

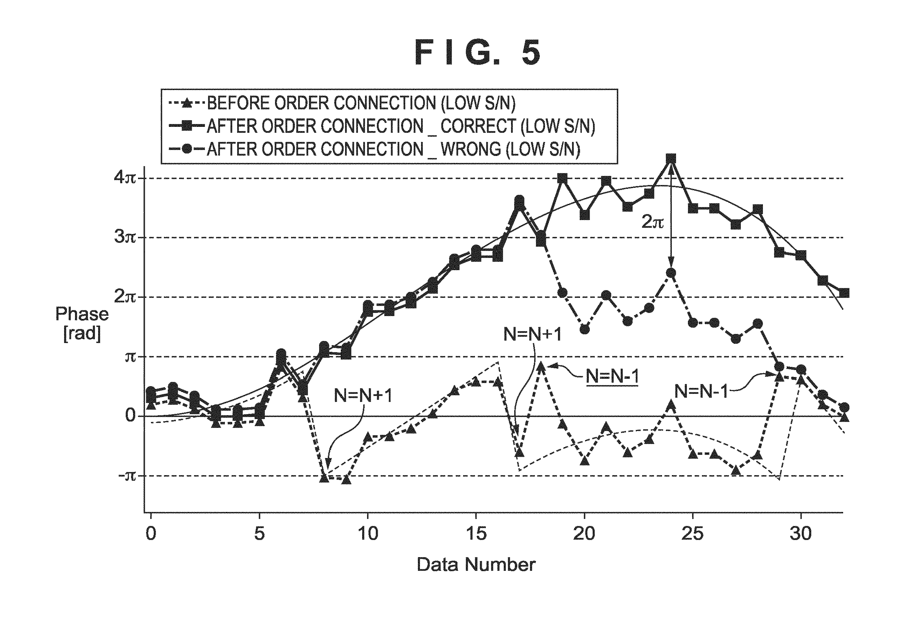

An order connecting calculator 216 connects an order by using the calculation result of equation (11). The order connection and the order connection error will be explained with reference to Figs. 4 and 5. First, a case in which the S/N ratio of a measurement signal is high will be explained with reference to Fig. 4. In Fig. 4, the ordinate represents the phase [rad], and the abscissa represents the data number. In Fig. 4, triangular points and a dotted line indicate the phase $\varphi(x, y, t)$ calculated by the arctangent calculator 215. The phase $\varphi(x, y, t)$ is calculated within a range of $-\pi$ to $+\pi$ in accordance with equation (11). The order connecting calculator 216 connects an order N for given data and the next data between which the phase difference is equal to larger than $\pi$. For example, the order N is set to $(N + 1)$ when the next data changes from the given data by $-\pi$ or more, and $(N - 1)$ when it changes by $+\pi$ or more. Data after the order connection is represented by $N + \varphi$. In Fig. 4, square points and a solid line indicate data after the order connection. Arrows in Fig. 4 indicate data points where order connection was executed, and order connection calculations. As shown in Fig. 4, if the order connection is successful, a smooth phase change is obtained.

Next, a case in which the S/N ratio of a measurement signal is low will be explained with reference to Fig. 5. A change of the phase is assumed to be the same as that in Fig. 4. When the S/N ratio of a measurement signal is low, a high- frequency noise component is added to digital signals having passed through the CIC filters 206 and 207, as represented by expressions (12) and (13) :

$$(G_{CIC}/2)C_1^{sig}(x, y, t)\sin(\varphi(x, y, t)) + Noise \qquad ...(12)$$

$$(G_{CIC}/2)C_1^{sig}(x, y, t)\cos(\varphi(x, y, t)) + Noise \qquad ...(13)$$

where Noise is the noise component. The noise component arises from fluctuations of the frequency of the light source 101, an error of the electric circuit system, a manufacturing error and adjustment error of the optical element, the surface shape of the object 111 to be measured, and the like. The biggest factor of the noise component is the surface shape of the object 111 to be measured.

Owing to the noise component, the phase $\varphi(x, y, t)$ calculated by the arctangent calculator 215 greatly varies. In Fig. 5, triangular points and a dotted line (thick line) indicate the state of variations. A thin dotted line indicates a case in which the S/N ratio of a measurement signal is high. The order connecting calculator 216 connects an order by using the phase $\varphi(x, y, t)$. In Fig. 5, square points and a thick solid line indicate a case in which the order connection has been performed correctly. A thin solid line indicates a case in which the S/N ratio of a measurement signal is high. In practice, however, the order connecting calculator 216 makes a mistaken in order connection, and executes a calculation of N = N - 1, as represented by data number 18 in Fig. 5. In Fig. 4, no such calculation is executed at data number 18. In Fig. 5, the erroneous order connection calculation is emphasized as an underlined mathematical equation. In Fig. 5, circular points and a chain line indicate a case in the order connection becomes wrong. After data number 18, all the data values shift by $2\pi$. This is the description of the order connection and the order connection error.

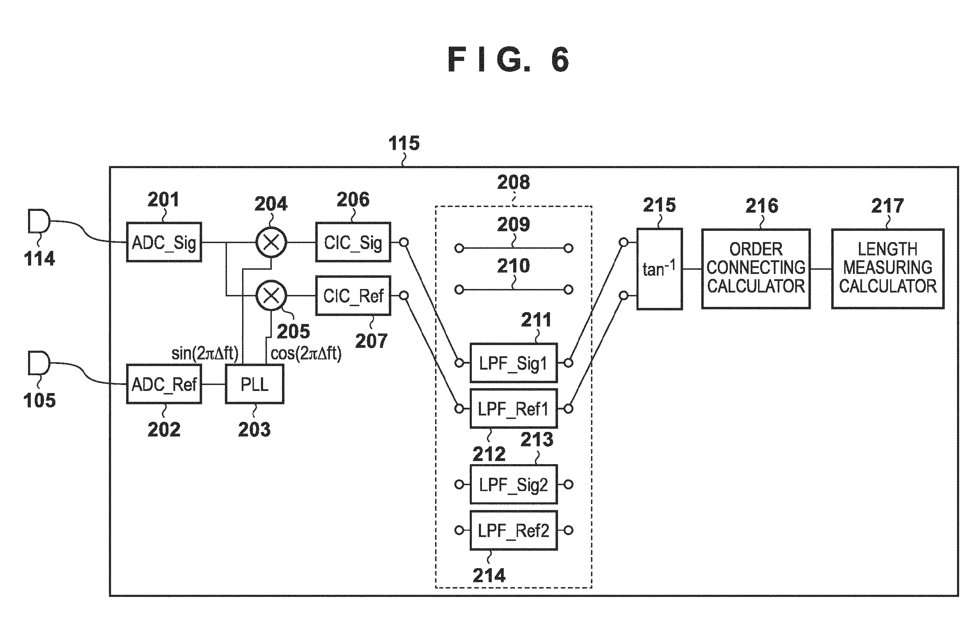

The description of the LPF switching circuit 208 as a feature of the first embodiment will be continued. When the S/N ratio of a measurement signal is low and an order connection error is generated, as described with reference to Fig. 5, LPFs are interposed between the CIC filters 206 and 207 and the arctangent calculator 215. LPFs 211 and 212 form a correction processing unit which corrects a sine signal and cosine signal to reduce noise components contained in them. Fig. 6 shows a phase calculating circuit in this case. The LPFs 211 and 212 have the frequency characteristic H(f) represented by equation (14) with respect to the frequency f :

$$H(f) = 1/\{1 + (f/f_{cutoff})^2\}^{1/2} \qquad \ldots (14)$$

where $f_{cutoff}$ is the cutoff frequency.

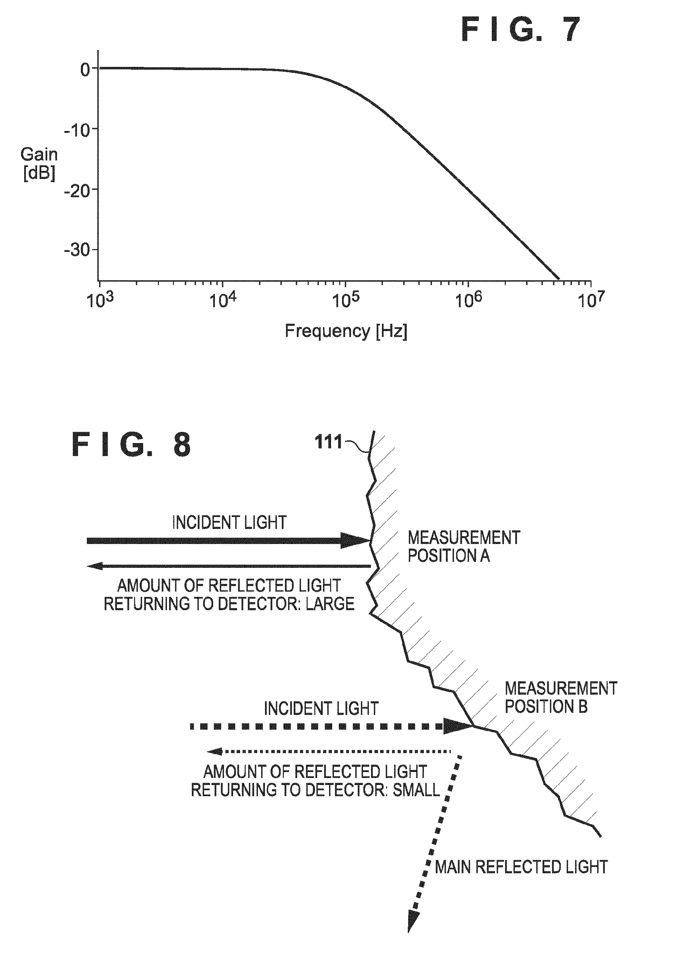

Fig. 7 shows the frequency characteristic H(f) of the LPFs 211 and 212 for $f_{cutoff}$ = 100 kHz. In Fig. 7, the ordinate represents the gain [dB], and the abscissa represents the frequency [Hz]. Unlike Fig. 3, the abscissa represents the frequency logarithmically. By causing the digital signals represented by expressions (12) and (13) to pass through the LPFs, the noise components in expressions (12) and (13) can be reduced. Therefore, the order connection error as described with reference to Fig. 5 can be reduced. Causing the digital signal to pass through the LPF means limiting the measurement rate by the cutoff frequency. If $\lambda_{sig}$ is 1 $\mu$m and the measurable Doppler shift is 2 MHz in the case of using no LPF (the case of Fig. 2), the maximum measurable rate is 1 m/sec. However, if $f_{cutoff}$ = 100 kHz in the case of using the LPFs (the case of Fig. 6), the maximum measurable rate becomes 50 nm/sec.

From this, the first embodiment switches the cutoff frequency $f_{cutoff}$ of the LPF depending on the magnitude of noise of the digital signals represented by expressions (12) and (13), that is, the S/N ratio. This is equivalent to using LPFs 213 and 214 in Fig. 6. For example, when the cutoff frequency of the LPFs 213 and 214 is set to $f_{cutoff}$ = 1000 kHz, the maximum measurable rate increases to 500 mm/sec though the noise component reduction ratio drops from that of the LPFs 211 and 212. In this manner, by appropriately switching between the LPFs having different cutoff frequencies $f_{cutoff}$ in the case of using no LPF and the case of using the LPFs, the order connection error can be reduced without excessively decreasing the maximum measurable rate.

Determination of the LPF switching operation will be explained with reference to Fig. 8. Fig. 8 shows the states of incident light and reflected light on the surface of the object 111 to be measured. In Fig. 8, arrows of solid lines represent light incident at a measurement position A and its reflected light. Arrows of dotted lines represent light incident at a measurement position B and its reflected light. At the measurement position A, the incident angle to the surface of the object 111 to be measured is almost 0, so the light amount of reflected light returning to the detector 114 is large. Near the measurement position A, the intensity of an interference signal hardly varies, and the S/N ratio of the interference signal is high. In contrast, at the measurement position B, the incident angle to the surface of the object 111 to be measured is large to a certain degree. For this reason, most of the light is reflected in a direction different from the direction of the detector 114, and the light amount of reflected light returning to the detector 114 decreases. The interference signal is readily affected by noise, and its intensity greatly varies, decreasing the S/N ratio of the interference signal at the measurement position B. That is, the S/N ratio increases when measurement light has no incident angle, and decreases when it has an incident angle. Information about the incident angle of measurement light can be obtained from the designed value of the surface shape of the object 111 to be measured. Thus, based on the designed value of the object 111 to be measured or the like, the processor 115 determines whether to switch the LPF. More specifically, an incident angle to the surface of the object 111 to be measured is calculated from data of the designed value. For example, it is set to use no LPF when the incident angle is smaller than 5°, use an LPF having a cutoff frequency of 1000 kHz when the incident angle has a value of 5° to 10°, and use an LPF having a cutoff frequency of 100 kHz when the incident angle is equal to or larger than 10°.

The LPF switching circuit 208 may always monitor the S/N ratio and determine switching of the LPF based on the monitoring result. That is, switching of the LPF can be determined based on variations of the intensity of an interference signal output from the detector 114 and variations of the intensity of a signal obtained from the interference signal. For example, the LPF switching circuit 208 always monitors variations of the intensity of a phase signal obtained from the interference signal that is calculated by the arctangent calculator 215. When the variations exceed a given threshold (for example, $\pi/3$), the LPF switching circuit 208 switches the LPF to one having a lower cutoff frequency. The LPF switching circuit 208 may determine switching of the LPF based on the result of directly measuring the S/N ratio of an interference signal.

Finally, a length measuring calculator 217 converts the order-connected phase {N + $\varphi$ (x, y, t) } into a surface position z by using equations (4) and (5). As described above, the measurement apparatus according to the first embodiment can reduce the order connection error even when the S/N ratio of an interference signal is low.

[Second Embodiment]

A measurement apparatus according to the second embodiment is a modification to the measurement apparatus according to the first embodiment, and is different in two points from the measurement apparatus according to the first embodiment. The first difference is that the measurement apparatus measures the surface position of an object 111 to be measured at a synthetic wavelength using a plurality of wavelengths. The second difference is that the measurement apparatus always uses one LPF without using the function of switching the LPF.

[Arrangement of Measurement Apparatus]

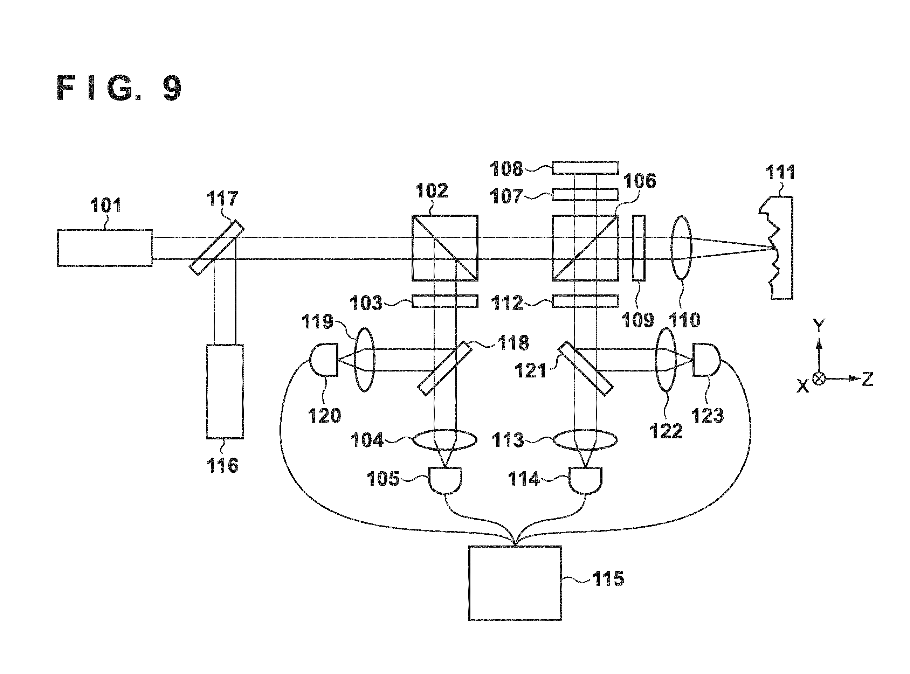

Fig. 9 is a view showing the measurement apparatus according to the second embodiment. A second light source 116 generates the second light having the second wavelength slightly different from the first wavelength of the first light generated by a first light source 101. $\lambda_1$ is the wavelength of the light source 101, and $\lambda_2$ is that of the light source 116. Since both the light sources 101 and 116 are heterodyne light sources, $\lambda_1$ and $\lambda_2$ are P-polarized light and S-polarized light having frequencies different by the beat frequency. Here, $\lambda_1$ and $\lambda_2$ are, for example, 1 $\mu$m, and the difference between $\lambda_1$ and $\lambda_2$ is 10 nm, which is 3 THz in frequency conversion. The beat frequency serving as the difference between P-polarized light and S-polarized light of the light sources 101 and 116 is about 20 MHz, as described in the first embodiment.

A spectral filter 117 multiplexes these beams. The spectral filter 117 is coated with a dielectric multilayered film to transmit light having $\lambda_1$ from the light source 101 and reflect light having $\lambda_2$ from the light source 116. The spectral characteristic of the spectral filter 117 does not change for only the difference of the beat frequency. The synthetic light reaches a non-polarization beam splitter 102, part of the incident light is reflected by the non-polarization beam splitter 102, and the remaining part passes through the non-polarization beam splitter 102. The light reflected by the non-polarization beam splitter 102 passes through an analyzer 103, and reaches a spectral filter 118. The spectral filter 118 is identical to the spectral filter 117. The spectral filter 118 reflects light from the light source 116, and transmits light from the light source 101. The light from the light source 101 that has passed through the spectral filter 118 enters a condenser lens 104 and is received by a detector 105. The light from the light source 116 that has been reflected by the spectral filter 118 enters a condenser lens 119 and is received by a detector 120. A reference signal having these two wavelengths is sent to a processor 115.

In contrast, the light having passed through the non-polarization beam splitter 102 reaches a polarization beam splitter 106. Subsequent steps are the same as those in the first embodiment until light passes through an analyzer 112, and a description thereof will not be repeated. The light having passed through the analyzer 112 reaches a spectral filter 121. The spectral filter 121 is identical to the spectral filter 117. The spectral filter 121 reflects light from the light source 116, and transmits light from the light source 101. The first interfering light generated by using the light from the light source 101 that has passed through the spectral filter 121 enters a condenser lens 113 and is received by a first detector 114. The second interfering light generated by using the light from the light source 116 that has been reflected by the spectral filter 121 enters a condenser lens 122 and is received by a second detector 123. The first interference signal output from the first detector 114 and the second interference signal output from the second detector 123 are sent to the processor 115.

[Calculation of Surface Position]

Next, calculation of the surface position using a synthetic wavelength $\Lambda$ will be explained. The synthetic wavelength $\Lambda$ is given by equation 15 using $\lambda_1$ and $\lambda_2$ :

$$\Lambda = \lambda_1\lambda_2 / |\lambda_1 - \lambda_2| \qquad \ldots (15)$$

The phase of an interference signal corresponding to the synthetic wavelength $\Lambda$ is given by expression (16) :

$$\{\varphi_1(x, y, t) - \varphi_2(x, y, t)\} \qquad \ldots (16)$$

where $\varphi_1(x, y, t)$ is the phase based on $\lambda_1$, and $\varphi_2(x, y, t)$ is the phase based on $\lambda_2$.

Calculating $\{\varphi_1(x, y, t) - \varphi_2(x, y, t)\}$ at high accuracy enables measurement based on the synthetic wavelength $\Lambda$. In the second embodiment, the synthetic wavelength $\Lambda$ is larger than the light source wavelengths $\lambda_1$ and $\lambda_2$. For this

reason, the Doppler shift generation amount decreases, compared to using the wavelengths $\lambda_1$ and $\lambda_2$ of the light sources 101 and 116. For example, the synthetic wavelength of 1-$\mu$m and 1.01-$\mu$m wavelengths is 101 $\mu$m, and the Doppler shift generation amount is reduced to about 1/100, compared to a 1-$\mu$m wavelength. Further, the use of the synthetic wavelength $\Lambda$ enables measurement even when the roughness in the diameter of a spot irradiating the object 111 to be measured is larger than the wavelengths $\lambda_1$ and $\lambda_2$. However, the measurement accuracy drops because the measurement scale becomes larger for the synthetic wavelength $\Lambda$. However, the measurement accuracy necessary for the actual object 111 to be measured is about 1 $\mu$m at most, a phase measurement accuracy of about 1/100 is usable for the synthetic wavelength of 101 $\mu$m, and the measurement accuracy for the synthetic wavelength $\Lambda$ is sufficient.

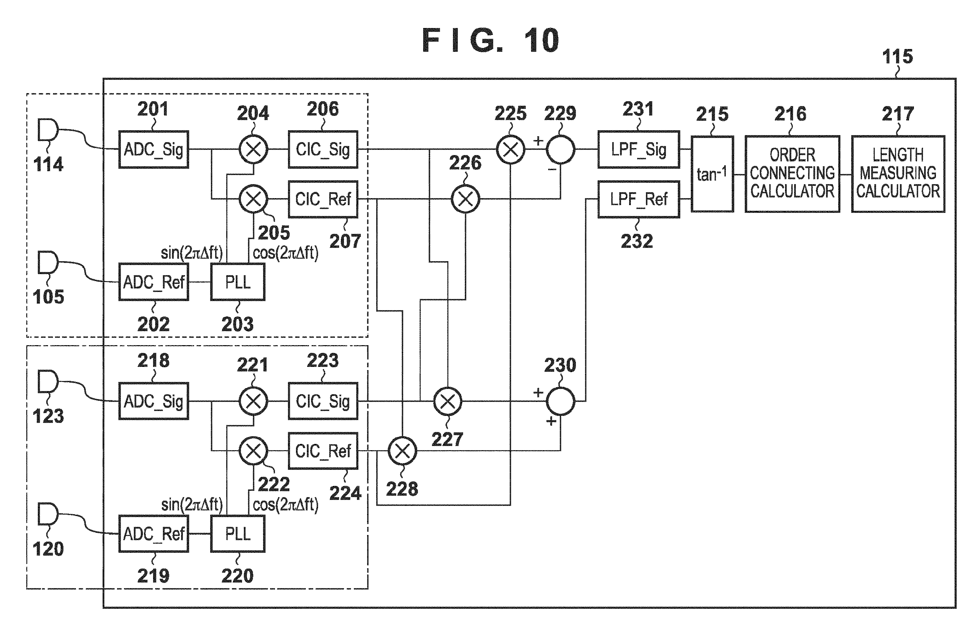

Fig. 10 shows a phase calculating circuit according to the second embodiment. Regions surrounded by a dotted line and chain line in Fig. 10 include the detectors 114, 105, 123, and 120, ADCs 201, 202, 218, and 219, PLLs 203 and 220, mixers 204, 205, 221, and 222, and CIC filters 206, 207, 223, and 224. The region surrounded by the dotted line is a processing part for the wavelength $\lambda_1$ of the light source 101, and the region surrounded by the chain line is a processing part for the wavelength $\lambda_2$ of the light source 116.

The processing contents of the respective units in the regions surrounded by the dotted line and chain line are the same as those in the first embodiment, and a description thereof will not be repeated.

Digital signals passing through the CIC filters 206, 207, 223, and 224 are given by expressions (17) to (20), respectively, in which proportionality coefficients are omitted for descriptive convenience:

$$\sin(\varphi_1(x, y, t)) \qquad \ldots (17)$$

$$\cos(\varphi_1(x, y, t)) \qquad \ldots (18)$$

$$\sin(\varphi_2(x, y, t)) \qquad \ldots (19)$$

$$\cos(\varphi_2(x, y, t)) \qquad \ldots (20)$$

Mixers 225 to 228 integrate the digital signals represented by expressions (17) to (20). The digital signals having passed through the mixers 225 to 228 are given by expressions (21) to (24), respectively:

$$\sin(\varphi_1(x, y, t))\cos(\varphi_2(x, y, t)) \qquad \ldots (21)$$

$$\cos(\varphi_1(x, y, t))\sin(\varphi_2(x, y, t)) \qquad \ldots (22)$$

$$\sin(\varphi_1(x, y, t))\sin(\varphi_2(x, y, t)) \qquad \ldots (23)$$

$$\cos(\varphi_1(x, y, t))\cos(\varphi_2(x, y, t)) \qquad \ldots (24)$$

The digital signals represented by expressions (21) and (24) are given by equations (25) and (26) using a subtracter 229 and adder 230, respectively:

$$\sin(\varphi_1(x,\ y,\ t))\cos(\varphi_2(x,\ y,\ t)) - \cos(\varphi_1(x,\ y,$$
$$t))\sin(\varphi_2(x,\ y,\ t)) = \sin(\varphi_1(x,\ y,\ t) - \varphi_2(x,\ y,\ t))$$

$$\dots(25)$$

$$\sin(\varphi_1(x,\ y,\ t))\sin(\varphi_2(x,\ y,\ t)) + \cos(\varphi_1(x,\ y,$$
$$t))\cos(\varphi_2(x,\ y,\ t)) = \cos(\varphi_1(x,\ y,\ t) - \varphi_2(x,\ y,\ t))$$

$$\dots(26)$$

As described above in the first embodiment, when the S/N ratio is low, a high-frequency noise component is added, so the digital signals having passed through the subtracter 229 and adder 230 are given by expressions (27) and (28), respectively:

$$\sin(\varphi_1(x,\ y,\ t) - \varphi_2(x,\ y,\ t)) + \text{Noise} \qquad \dots(27)$$

$$\cos(\varphi_1(x,\ y,\ t) - \varphi_2(x,\ y,\ t)) + \text{Noise} \qquad \dots(28)$$

The digital signals represented by expressions (27) and (28) pass through LPFs 231 and 232. The LPFs 231 and 232 reduce the high-frequency noise components. Since the second embodiment uses the synthetic wavelength, as described above, the Doppler shift generation amount is reduced. For example, when the surface position is measured at a single light source wavelength of 1 $\mu$m and the cutoff frequency $f_{cutoff}$ of the LPF = 100 kHz without using the synthetic wavelength, the maximum measurable rate is limited to 50 mm/sec. In the second embodiment, however, the maximum measurable rate increases to 5 m/sec by using the 101-$\mu$m synthetic wavelength of the 1-$\mu$m and 1.01-$\mu$m light source wavelengths. Compared to the first embodiment, the maximum measurable rate has a sufficient margin, and the necessity to switch the LPF is small. For this reason, the second embodiment can remove a high-frequency noise component generated when the S/N ratio is low, without arranging the mechanism for switching the LPF.
An arctangent calculator 215 obtains phase data represented by expression (29) from the digital signals having passed through the LPFs 231 and 232:

$$\{\varphi_1(x,\ y,\ t) - \varphi_2(x,\ y,\ t)\} \qquad \dots(29)$$

The calculated phase data passes through an order connecting calculator 216 and length measuring calculator 217, and is converted into a surface position z. As described above, the second embodiment can reduce the order connection error even when the S/N ratio of an interference signal is low. The first and second embodiments adopt the heterodyne method. However, the present invention is also applicable to even the homodyne method because the homodyne method similarly executes arctangent calculation after calculating the sine and cosine components of a phase to be calculated.

[Third Embodiment]

A measurement apparatus according to the third embodiment is different from the measurement apparatus according to the first embodiment in that the high-frequency noise component of an interference signal having a beat frequency is removed using a bandpass filter (BPF), instead of removing the noise components of the sine and cosine components of the phase of an interference signal. The measurement apparatus according to the third embodiment is different from the measurement apparatus according to the first embodiment only in the internal arrangement of a processor 115.

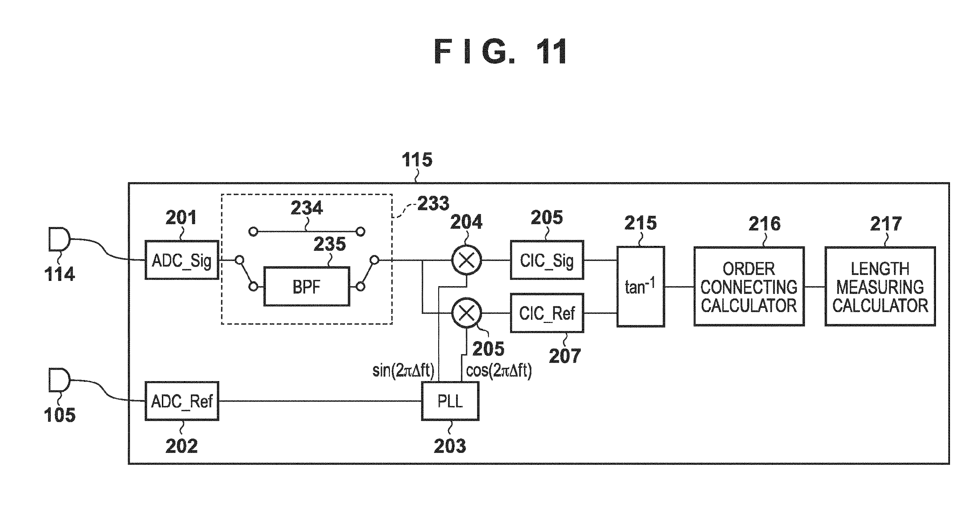

Next, a surface position calculation method in the third embodiment will be explained. Fig. 11 shows a phase calculating circuit according to the third embodiment. The third embodiment is different from the first embodiment in that the digital signal of a measurement signal output from an ADC 201 passes through a BPF switching circuit 233 surrounded by a dotted line. The BPF switching circuit 233 includes a straight circuit 234 and BPF 235. The BPF 235 is designed so that the center frequency becomes equal to the beat frequency Δf. The BPF 235 can remove a noise component other than the beat frequency. Also, similar to the first embodiment, the circuit can be switched between the straight circuit 234 and the BPF 235 between an interference signal having a high S/N ratio and an interference signal having a low S/N ratio. Determination of switching is the same as that in the first embodiment. Even when the S/N ratio of an interference signal is low, a signal equivalent to a  signal obtained when the S/N ratio is high can be obtained. As a result, an order connecting calculator 216 can reduce an order connection error. Although Fig. 11 shows only one type of BPF 235, a plurality of BPFs having different bandwidths may be prepared and the BPF to be used may be switched in accordance with a generated Doppler shift amount or the like.

The third embodiment has described the phase calculation method using the heterodyne method and BPF. However, the present invention is also applicable to the homodyne method because the homodyne method can obtain the same effects by using an LPF instead of the BPF.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions. A measurement apparatus, which measures a surface position of an object (111) by detecting interfering light between measurement light reflected by the object and reference light reflected by a reference surface, includes: a detector (114) configured to detect the interfering light to output an interference signal; and a processor (115) configured to obtain the surface  position based on a sine signal and a cosine signal which are obtained from the interference signal output from the detector and have a phase corresponding to an optical path length difference between the measurement light and the reference light. The processor includes a correction processing unit (211, 212, 213, 214) configured to correct the sine signal and the cosine signal to reduce frequency noise components contained in the sine signal and the cosine signal.

**Claims**

1. A measurement apparatus which measures a surface position of an object (111) to be measured by detecting interfering light between measurement light reflected by the object to be measured and reference light reflected by a reference surface, the apparatus **characterized by** comprising:

   a detector (114) configured to detect the interfering light to output an interference signal; and
   a processor (115) configured to obtain the surface position based on a sine signal and a cosine signal which are obtained from the interference signal output from said detector and have a phase corresponding to an optical path length difference between the measurement light and the reference light,
   wherein said processor includes a correction processing unit (211, 212, 213, 214) configured to correct the sine signal and the cosine signal to reduce frequency noise components contained in the sine signal and the cosine signal.

2. The apparatus according to claim 1, **characterized in that**
   based on at least one of a designed value of a surface shape of the object to be measured, a variation of an intensity of the interference signal output from said detector, and a variation of an intensity of a signal obtained from the interference signal, said  processor determines whether to perform correction by said correction processing unit, when said processor determines to perform the correction, said correction processing unit corrects the sine signal and the cosine signal, and said processor obtains the surface position based on the corrected sine signal and the corrected cosine signal.

3. A measurement apparatus which measures a surface position of an object (111) to be measured by detecting interfering light between measurement light reflected by the object to be measured and reference light reflected by a reference surface, the apparatus **characterized by** comprising:

   a detector (114) configured to detect the interfering light to output an interference signal; and
   a processor (115) configured to obtain the surface position based on a sine signal and a cosine signal which are obtained from the interference signal output from said detector and have a phase corresponding to an optical path length difference between the measurement light and the reference light,

wherein said processor includes a correction processing unit (235) configured to correct the interference signal to reduce a frequency noise component contained in the interference signal.

4. The apparatus according to claim 3, **characterized in that**
based on at least one of a designed value of a surface shape of the object to be measured, a variation of an intensity of the detected interference signal output from said detector, and a variation of an intensity of a signal obtained from the interference signal, said processor determines whether to perform correction by said correction processing unit, when said processor determines to perform the correction, said correction processing unit corrects the interference signal, and said processor obtains the surface position based on a sine signal and a cosine signal derived from the corrected interference signal.

5. The apparatus according to any one of claims 1 to 4, **characterized in that** said correction processing unit includes at least one filter which reduces the frequency noise component.

6. The apparatus according to claim 5, **characterized in that**
said correction processing unit includes a plurality of filters having different frequency characteristics, and based on at least one of a designed value of a surface shape of the object to be measured, a variation of an intensity of the detected interference signal, and a variation of an intensity of a signal obtained from the interference signal, said processor switches a filter to be used to reduce the frequency noise component.

7. A measurement apparatus which measures a surface position of an object (111) to be measured by detecting interfering light between measurement light reflected by the object to be measured and reference light reflected by a reference surface, the apparatus **characterized by** comprising:

   a first light source (101) configured to generate first light of a first wavelength;
   a second light source (116) configured to generate second light of a second wavelength;
   a first detector (114) configured to detect first interfering light generated using the first light, and outputs a first interference signal;
   a second detector (123) configured to detect second interfering light generated using the second light, and outputs a second interference signal; and
   a processor (115) configured to obtain the surface position based on the first interference signal and the second interference signal,
   wherein said processor obtains, from the first interference signal and the second interference signal, a sine signal and a cosine signal having a phase of an interference signal corresponding to a synthetic wavelength of the first wavelength and the second wavelength, corrects the sine signal and the cosine signal to reduce frequency noise components contained in the obtained sine signal and the obtained cosine signal, and obtains the surface position by using the corrected sine signal and the corrected cosine signal, and
   the synthetic wavelength is larger than the first wavelength and the second wavelength.

8. A measurement method of measuring a surface position of an object (111) to be measured by detecting interfering light between measurement light reflected by the object to be measured and reference light reflected by a reference surface, the method **characterized by** comprising the steps of :

   detecting the interfering light to output an interference signal;
   correcting a sine signal and a cosine signal which are obtained from the output interference signal and have a phase corresponding to an optical path length difference between the measurement light and the reference light, to reduce frequency noise components contained in the sine signal and the cosine signal; and
   obtaining the surface position based on the corrected sine signal and the corrected cosine signal.

9. A measurement method of measuring a surface position of an object (111) to be measured by detecting interfering light between measurement light reflected by the object to be measured and reference light reflected by a reference surface, the method **characterized by** comprising the steps of :

   detecting the interfering light to output an interference signal;
   correcting the interference signal to reduce a frequency noise component contained in the output interference signal; and
   obtaining, from the corrected interference signal, a sine signal and a cosine signal having a phase corresponding to an optical path length difference between the measurement light and the reference light, and obtaining the surface position based on the obtained sine signal and the obtained cosine signal.

10. A measurement method of measuring a surface position of an object (111) to be measured by detecting interfering light between measurement light reflected by the object to be measured and reference light reflected by a reference surface, the method **characterized by** comprising the steps of :

detecting first interfering light generated using first light of a first wavelength from a first light source (101) to output a first interference signal;
detecting second interfering light generated using second light of a second wavelength from a second light source (116) to output a second interference signal; and
obtaining the surface position based on the first interference signal and the second interference signal, wherein a sine signal and a cosine signal having a phase of an interference signal corresponding to a synthetic wavelength of the first wavelength and the second wavelength are obtained from the first interference signal and the second interference signal, the sine signal and the cosine signal are corrected so as to reduce frequency noise components contained in the obtained sine signal and the obtained cosine signal, and the surface position is obtained by using the corrected sine signal and the corrected cosine signal, and
the synthetic wavelength is larger than the first wavelength and the second wavelength.

11. The apparatus according to claim 1, **characterized in that** the frequency noise components includes a high-frequency noise component.

12. The apparatus according to claim 3, **characterized in that** the frequency noise components includes a frequency noise component other than a beat frequency.

# FIG. 1

# F I G. 2

EP 2 648 044 A2

# F I G. 3

# FIG. 4

EP 2 648 044 A2

# FIG. 5

Legend:
- ···▲··· BEFORE ORDER CONNECTION (LOW S/N)
- ─■─ AFTER ORDER CONNECTION _ CORRECT (LOW S/N)
- ─●─ AFTER ORDER CONNECTION _ WRONG (LOW S/N)

Y-axis: Phase [rad]

X-axis: Data Number

EP 2 648 044 A2

# FIG. 6

EP 2 648 044 A2

# FIG. 7

Gain [dB] vs Frequency [Hz]

# FIG. 8

111

INCIDENT LIGHT

MEASUREMENT POSITION A

AMOUNT OF REFLECTED LIGHT RETURNING TO DETECTOR: LARGE

MEASUREMENT POSITION B

INCIDENT LIGHT

AMOUNT OF REFLECTED LIGHT RETURNING TO DETECTOR: SMALL

MAIN REFLECTED LIGHT

F I G. 9

# FIG. 10

EP 2 648 044 A2

# F I G. 11

EP 2 648 044 A2

**EP 2 648 044 A2**

## REFERENCES CITED IN THE DESCRIPTION

**Patent documents cited in the description**

- JP 2008510170 A

- JP 2006170796 A